# EUROPEAN PATENT SPECIFICATION

(11) **EP 4 425 524 B1**
(45) Date of publication and mention of the grant of the patent: **03.09.2025**
(21) Application number: 23206216.6
(22) Date of filing: 26.10.2023
(51) Int. Cl.: H01H 47/00, B60L 3/00, B60L 3/12, B60L 3/04

(54) **SWITCH CONTROL DEVICE, BATTERY PACK AND VEHICLE INCLUDING THE SAME**
SCHALTSTEUERUNGSVORRICHTUNG, BATTERIEPACK SOWIE FAHRZEUG DAMIT
DISPOSITIF DE COMMANDE DE COMMUTATEUR, BLOC-BATTERIE ET VÉHICULE LE COMPRENANT

(30) Priority: 03.03.2023 KR 20230028669
(43) Date of publication of application: 04.09.2024
(73) Proprietor: Samsung SDI Co., Ltd., Yongin-si, Gyeonggi-do 17084 (KR)
(72) Inventor: JEON, Hyuncheol, 17084 Yongin-si (KR)
(74) Representative: Marks & Clerk LLP

(56) References cited:
- FR-A1- 3 126 209
- US-A1- 2019 244 779
- US-B2- 10 746 802

## Description

### BACKGROUND OF THE DISCLOSURE

### (a) Field of the Disclosure

The present disclosure relates to a switch control device, and a battery pack and a vehicle including the same.

### (b) Description of the Related Art

As environmental regulation such as CO₂ regulation or the like has been recently strengthened, interest in an environmentally-friendly vehicle has increased. Accordingly, automobile companies are actively conducting research and product development on a pure electric vehicle or a hydrogen vehicle as well as a hybrid vehicle or a plug-in hybrid vehicle.

A high-voltage battery pack is applied to the environmentally-friendly vehicle to store electric energy obtained from various energy sources. A high-voltage electrical system of the vehicle uses high-voltage electric energy provided from a high-voltage battery as driving or electrical energy of the vehicle.

An output of the high-voltage battery pack may be transferred to or blocked from a load by a high-voltage switch such as a relay, a contactor, or the like. An abnormal operation of the high-voltage switch such as chattering or the like may cause welding of a contact to greatly affect lifespan of the high-voltage switch. The abnormal operation of the high-voltage switch may be monitored and detected by a controller such as a microcontroller or the like. However, when the controller abnormally operates due to a reset or the like, there is a problem in which the abnormal operation of the high-voltage switch may not be detected.

US 10 746 802 B2 discloses a system and a method in which a contactor coil control unit, which applies an operation signal to a contactor coil (relay coil) that opens or connects contact points of a contactor (Relay), during a travelling of a vehicle applies an abnormal signal to the contactor coil by an external reason or a failure, the abnormal signal is detected in real time, so that it is possible to prevent the contact point of the contactor from being unintentionally opened by the abnormal signal.

### SUMMARY OF THE DISCLOSURE

A problem to be solved by the present disclosure is to provide a switch control device capable of detecting a malfunction of a high-voltage switch occurring in a section where a controller abnormally operates, and a battery pack and a vehicle including the switch control device.

A switch control device, a battery pack, and a vehicle, according to an embodiment for solving the above problem are defined in the appended claims.

### BRIEF DESCRIPTION OF THE DRAWINGS

FIG. 1 schematically illustrates a switch control device according to an embodiment.
FIG. 2 schematically illustrates a vehicle including the switch control device according to an embodiment.
FIG. 3 schematically illustrates an operating method of the switch control device according to an embodiment.

### DETAILED DESCRIPTION OF THE EMBODIMENTS

Embodiments of the present disclosure will now be described in detail with accompanying drawings. Effects and characteristics of embodiments, and a realization method thereof will now be described in detail with accompanying drawings. In the drawings, same reference numerals indicate same constituent elements, and no repeated descriptions thereof will be provided. As those skilled in the art would realize, the described embodiments may be modified in various different ways, all without departing from the scope of the present disclosure. The embodiments are provided as examples to assist the understanding of the invention by a person skilled in the art.

Hence, for the purpose of understanding the present disclosure, processes, factors, and skills that may be part of the common general knowledge of a person of ordinary skill in the art may not be described. In the drawings, relative sizes of elements, layers, and regions may be exaggerated for clarity.

In the present specification, the term "and/or" includes all of or any combination of a plurality of items that are related and arranged. When the embodiments of the present disclosure are described, the use of "can" or "may" signifies at least one embodiment of the present disclosure. Regarding the description on an embodiment of the present disclosure, a singular term may include a plural form unless stated in another way.

In the present specification, terms including ordinal numbers such as first and second will be used only to describe various components, and are not to be interpreted as limiting these components. The terms are only used to differentiate one component from other components. For example, a first constituent element could be termed a second constituent element, and similarly, a second constituent element could be termed a first constituent element, without departing from the scope of the present disclosure.

It will be understood that when a constituent element or layer is referred to as being "on," "connected to," or "coupled to" another constituent element or layer, it can be directly on, connected to, or coupled to the other constituent element or layer, or one or more intervening constituent elements or layers may be present. In addition, it will also be understood that when a constituent element or layer is referred to as being "between" two constituent elements or layers, it can be the only constituent element or layer between the two constituent elements or layers, or one or more intervening constituent elements or layers may also be present.

Electrically connecting two constituent elements includes directly connecting two constituent elements, and connecting the same with another constituent element therebetween. The other constituent element may include a switch, a resistor, a capacitor, or the like. When the embodiments are described, an expression of connection signifies electrical connection when an expression of direct connection is not provided.

Hereinafter, a switch control device according to an embodiment, and a battery pack and a vehicle including the switch control device will be described in detail with reference to necessary drawings.

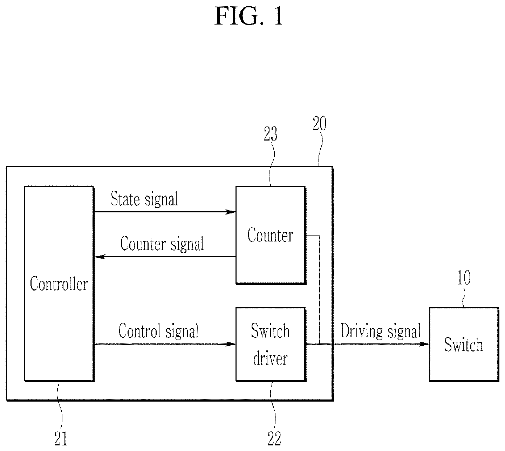

FIG. 1 schematically illustrates the switch control device according to the embodiment.

Referring to FIG. 1, the switch control device 20 according to the embodiment may include a controller 21, a switch driver 22, and a counter 23.

The controller 21 may output a control signal for controlling opening and closing of the switch 10 to the switch driver 22. The controller 21 may output a state signal (e.g., a reset signal) indicating an operating state of the controller 21 to the counter 23. The controller 21 may be configured as a processor having a physically structured circuit to perform a function represented by a code or a command included in a program such as a microprocessor, a microcontroller, a central processing unit (CPU), a processor core, a multiprocessor, an application-specific integrated circuit (ASIC), a field-programmable gate array (FPGA), or the like.

The state of the controller 21 may be monitored by a watchdog component inside the controller 21 or a watchdog circuit outside the controller 21. The watchdog component or the watchdog circuit may reset the controller 21 if an abnormal state of the controller 21 is detected. As reset, the controller 21 may output the state signal indicating an abnormal state until it returns to the normal state.

The switch driver 22 may output a driving signal for controlling opening and closing of the switch 10 according to the control signal received from the controller 21. The switch 10 may be configured as a switch element in which a contact state (a closed state of the switch 10) and a non-contact state (an open state of the switch 10) of contacts are controlled by whether a coil is energized. For example, the switch element may include a relay, a contactor, or the like. In this case, the switch driver 22 may be connected to at least one of both ends of the coil for operating the switch 10 to control opening and closing of the switch 10 by controlling energization of the coil using the driving signal.

The counter 23 may receive the state signal of the controller 21 from the controller 21. The counter 23 may be connected between an output terminal of the switch driver 22 and the switch 10 (that is, the counter 23 may be connected to the output terminal of the switch driver 22 or one of both ends of the coil of the switch 10) to count the number of times (hereinafter referred to as the number of switch operations) that the switch 10 is operated in an open or closed state in response to the driving signal output from the switch driver 22. In other words, the counter 23 counts the number of times that the switch is turned on or off. The counter 23 may start or end counting the number of switch operations according to the state signal of the controller 21. The counter 23 may start counting the number of switch operations when the state signal received from the controller 21 indicates that the controller 21 enters an abnormal state (e.g., a reset state). The counter 23 may end counting of the number of switch operations when the state signal received from the controller 21 indicates that the controller 21 returns to a normal state.

The counter 23 may output to the controller 21 information on the number of switch operations counted while the controller 21 operates in the abnormal state. The controller 21 receiving information on the number of switch operations may detect an abnormal operation of the switch 10 based on the number of switch operations. When the number of switch operations is greater than or equal to a threshold value, the controller 21 may determine that a failure occurs in the switch driver 22, and may notify an upper controller (e.g., a controller of a system (e.g., a vehicle) at which the battery pack 100 is mounted) of the failure.

If the controller (21) operates in an abnormal state, the switch driver (22) may not change the status of the switch (10) or may change it once. For example, if the controller (21) operates in an abnormal state, the switch driver (22) may maintain the previous state of the switch (10) for a certain period of time. For example, if the controller (21) operates in an abnormal state, the switch driver (22) may change the state of the switch (10) once (for example, changing from a closed state to an open state). The operation of the switch driver (22) while the controller (21) operates in an abnormal state may vary depending on the configuration of the switch driver (22). Therefore, the threshold value may be determined according to the configuration of the switch driver (22). The threshold value may be set to 1 or 2. If chattering occurs, the switch (10) may operate multiple times, so the threshold value man be set to a value greater than 2 to prevent misrecognition.

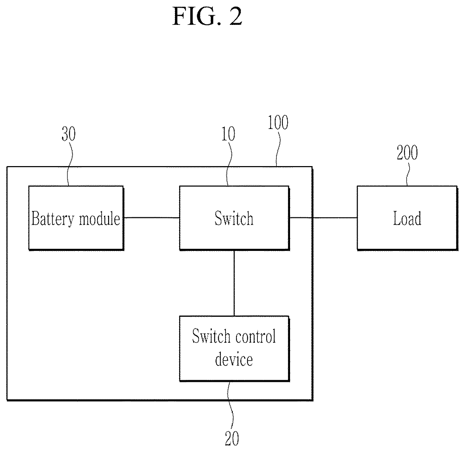

FIG. 2 schematically illustrates the vehicle including the switch control device 20 according to an embodiment.

Referring to FIG. 2, the vehicle may include the battery pack 100 and a load 200 receiving electric power from the battery pack 100. The battery pack 100 may include the switch 10, the switch control device 20, and a battery module 30.

The battery module 30 may include cells connected in series or parallel to each other.

The switch 10 may control electrical connection between the battery module 30 and the load 200. The switch 10 may include a contactor, a relay, or the like.

The switch control device 20 may control an open or closed state of the switch 10. As described with reference to FIG. 1, the switch control device 20 may include the controller 21, the switch driver 22, and the counter 23.

The controller 21 of the switch control device 20 may be a battery management system (BMS) of the battery pack 100. In this case, the controller 21 may output the state signal indicating the operating state of the controller 21, the control signal for controlling the opening and closing of the switch 10, and the like based on state information of the battery module 30, state information of a system (e.g., the vehicle) at which the battery pack 100 is mounted, a driving mode, or the like. For example, the controller 21 may determine whether the switch 10 is opened or closed according to a state of the battery pack 100 or a state of the system (the vehicle) at which the battery pack 100 is mounted, and may output the control signal for controlling the opening and closing of the switch 10 to the switch.

The switch 10 mounted at the battery pack 100 may abnormally operate due to various factors such as an inrush current, high current conduction, a power noise, a malfunction of the switch driver 22, and the like even while the controller 21 abnormally operates. As described above, the switch control device 20 may detect the number of times that the switch 10 is abnormally opened or closed while the controller 21 abnormally operates, and may detect the abnormal operation of the switch 10 based on the detected number of times.

The controller 21 of the switch control device 20 may detect a malfunction of the switch 10 while the controller 21 abnormally operates based on the information on the number of switch operations received from the counter 23. When the malfunction of the switch 10 is detected, the switch control device 20 may provide information on the detected malfunction of the switch to a controller of the system (the vehicle) at which the battery pack 100 is mounted. When the number of switch operations counted while the controller 21 abnormally operates is greater than or equal to the threshold value, the switch control device 20 may determine that a failure occurs in the switch driver 22, and may notify the controller of the system (the vehicle) at which the battery pack 100 is mounted of the failure of the switch driver 22.

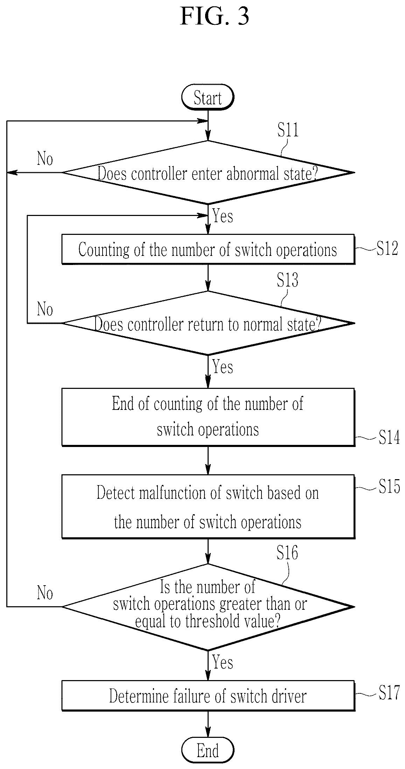

FIG. 3 schematically illustrates an operating method of the switch control device 20 according to an embodiment.

Referring to FIG. 3, the switch control device 20 according to the embodiment may determine whether the controller 21 enters the abnormal state based on the state signal (e.g., the reset signal) output from the controller 21 (S11). When the controller 21 enters the abnormal state, the switch control device 20 may count the number of switch operations (S12). The number of switch operations is the number of times that the switch 10 is operated in the open or closed state by the driving signal output from the switch driver 22.

Thereafter, when it is confirmed that the controller 21 returns to the normal state based on the state signal output from the controller 21 in a step S13, the switch control device 20 may end counting the number of switch operations (S14). In addition, the switch control device 20 may detect the malfunction of the switch 10 while the controller 21 operates in the abnormal state based on the counted number of switch operations (S15). When the counted number of switch operations is greater than or equal to the threshold value in a step S16, the switch control device 20 may determine that a failure of the switch driver 22 has occurred rather than a temporary malfunction of the switch driver 22 (S17), and may notify an upper controller (e.g., a controller of a system (e.g., a vehicle) at which the battery pack 100 is mounted) of a system at which the switch control device 20 is installed of the failure.

Electronic or electrical devices according to embodiments of the present disclosure and/or other related devices or constituent elements may be realized by using appropriate hardware, firmware (e.g., an application-specific integrated circuit), software, or combinations of software, firmware, and hardware. For example, various configurations of the above-noted devices may be positioned on one integrated circuit (IC) chip or an individual IC chip. In addition, various configurations of the above-noted devices may be realized on a flexible printed circuit film, a tape carrier package (TCP), a printed circuit board (PCB), or one substrate. The electrical or mutual connections described in the present specification may, for example, be realized by the PCB, wires on different types of circuit carriers, or conductive elements. The conductive elements may, for example, include metallization such as surface metallizations and/or pins, and may include conductive polymers or ceramics.

In addition, the various configurations of the devices may be performed by at least one processor so as to perform the above-described various functions, they may be performed in at least one computing device, and they may be processes or threads for performing computer program instructions and interacting with other system constituent elements. The computer program instruction is stored in a memory realizable in a computing device using a standard memory device such as a random access memory (RAM). The computer program instruction may also be stored in a non-transitory computer readable medium such as a CD-ROM or a flash drive.

Further, a person of ordinary skill in the art must understand that various functions of the computing device may be combined or united to a single computing device, or functions of a specific computing device may be dispersed to at least another computing device while not digressing from the range of the embodiments of the present disclosure.

### <Description of symbols>

10: switch
20: switch control device
21: controller
22: switch driver
23: counter
100: battery pack
200: load

## Claims

1. A switch control device (20), comprising:
a controller (21) configured to output a control signal controlling opening and closing of a switch (10);
a switch driver (22) configured to output a driving signal controlling opening and closing of the switch (10) to the switch (10) according to the control signal;
**characterised in that**
a counter (23) connected between an output terminal of the switch driver (22) and the switch (10), configured to receive a state signal indicating an operating state of the controller (21) from the controller (21), and to count a number of times that the switch (10) is operated in an open or closed state by the driving signal when the state signal indicates an abnormal state of the controller (21),
wherein the controller (21) is further configured to detect a malfunction of the switch (10) while the controller (21) operates in an abnormal state based on the number of times.

2. The switch control device (20) of claim 1, wherein the state signal is a reset signal of the controller (21), and the counter (23) is further configured to start or end counting of the number of times according to the reset signal.

3. The switch control device (20) of any preceding claim, wherein the controller (21) is further configured to determine that a failure occurs in the switch driver (22) when the number of times is greater than or equal to a threshold value.

4. A battery pack (100) comprising:
a battery module (30);
a switch (10) configured to control electrical connection between the battery module (30) and a load (200) configured to receive electric power from the battery pack; and
a switch control device (20) according to any one of claims 1 to 3 that is configured to control the switch (10).

5. The battery pack (100) of claim 4, wherein the switch (10) is a relay or a contactor whose opening and closing is controlled by energization of a coil included in the switch (10), and the switch driver (22) is further configured to output the driving signal to at least one of both ends of the coil.

6. The battery pack (100) of claim 5, wherein the counter (23) is connected to the output terminal of the switch driver (22) or one of the both ends of the coil.

7. A vehicle comprising:
a battery pack (100) according to any of claims 4, 5, and 6; and
a load (200) configured to receive electric power from the battery pack (100).

## Patentansprüche

1. Schaltersteuerungseinrichtung (20), die Folgendes umfasst:
ein Steuergerät (21), das dafür konfiguriert ist, ein Steuersignal auszugeben, das Öffnen und Schließen eines Schalters (10) steuert,
einen Schaltertreiber (22), der dafür konfiguriert ist, ein Treibersignal, das Öffnen und Schließen des Schalters (10) steuert, entsprechend dem Steuersignal an den Schalter (10) auszugeben,
**dadurch gekennzeichnet, dass**
ein Zähler (23), der zwischen einem Ausgangsanschluss des Schaltertreibers (22) und dem Schalter (10) angeschlossen ist, dafür konfiguriert ist, ein Zustandssignal, das einen Betriebszustand des Steuergeräts (21) anzeigt, von dem Steuergerät (21) zu empfangen und eine Anzahl von Malen zu zählen, die der Schalter (10) durch das Treibersignal in einem offenen oder geschlossenen Zustand betätigt wird, wenn das Zustandssignal einen anormalen Zustand des Steuergeräts (21) anzeigt,
wobei das Steuergerät (21) ferner dafür konfiguriert ist, eine Fehlfunktion des Schalters (10), während das Steuergerät (21) in einem anormalen Zustand arbeitet, auf Grundlage der Anzahl von Malen zu erkennen.

2. Schaltersteuerungseinrichtung (20) nach Anspruch 1, wobei das Zustandssignal ein Rückstellsignal des Steuergeräts (21) ist und der Zähler (23) ferner dafür konfiguriert ist, das Zählen der Anzahl von Malen entsprechend dem Rückstellsignal zu beginnen oder zu beenden.

3. Schaltersteuerungseinrichtung (20) nach einem der vorhergehenden Ansprüche, wobei das Steuergerät (21) ferner dafür konfiguriert ist, festzustellen, dass eine Störung in dem Schaltertreiber (22) auftritt, wenn die Anzahl von Malen größer als oder so groß wie ein Schwellenwert ist.

4. Batteriepaket (100), das Folgendes umfasst:
ein Batteriemodul (30),
einen Schalter (10), der dafür konfiguriert ist, eine elektrische Verbindung zwischen dem Batteriemodul (30) und einer Last (200), die dafür konfiguriert ist, Elektroenergie von dem Batteriepaket zu empfangen, zu steuern, und
eine Schaltersteuerungseinrichtung (20) nach einem der Ansprüche 1 bis 3, die dafür konfiguriert ist, den Schalter (10) zu steuern.

5. Batteriepaket (100) nach Anspruch 4, wobei der Schalter (10) ein Relais oder ein Schaltschütz ist, dessen Öffnen und Schließen durch Erregung einer in dem Schalter (10) eingeschlossenen Spule gesteuert wird, und der Schaltertreiber (22) ferner dafür konfiguriert ist, das Treibersignal an mindestens eines von beiden Enden der Spule auszugeben.

6. Batteriepaket (100) nach Anspruch 5, wobei der Zähler (23) mit dem Ausgangsanschluss des Schaltertreibers (22) oder einem von den beiden Enden der Spule verbunden ist.

7. Fahrzeug, das Folgendes umfasst:
ein Batteriepaket (100) nach einem der Ansprüche 4, 5 und 6 und
eine Last (200), die dafür konfiguriert ist, Elektroenergie von dem Batteriepaket (100) zu empfangen.

## Revendications

1. Dispositif de commande de commutateur (20), comprenant :
un contrôleur (21) configuré pour émettre en sortie un signal de commande qui commande l'ouverture et la fermeture d'un commutateur (10) ; et
un pilote de commutateur (22) configuré pour émettre en sortie sur le commutateur (10) un signal de pilotage qui commande l'ouverture et la fermeture du commutateur (10) en fonction du signal de commande ;
**caractérisé en ce que** :
un compteur (23) connecté entre une borne de sortie du pilote de commutateur (22) et le commutateur (10), configuré pour recevoir un signal d'état indiquant un état de fonctionnement du contrôleur (21) en provenance du contrôleur (21) et pour compter un nombre de fois où le commutateur (10) est activé dans un état ouvert ou fermé par le signal de pilotage lorsque le signal d'état indique un état anormal du contrôleur (21),
dans lequel le contrôleur (21) est en outre configuré pour détecter un dysfonctionnement du commutateur (10) tandis que le contrôleur (21) fonctionne dans un état anormal sur la base du nombre de fois.

2. Dispositif de commande de commutateur (20) selon la revendication 1, dans lequel le signal d'état est un signal de réinitialisation du contrôleur (21), et le compteur (23) est en outre configuré pour démarrer ou arrêter le comptage du nombre de fois en fonction du signal de réinitialisation.

3. Dispositif de commande de commutateur (20) selon l'une quelconque des revendications précédentes, dans lequel le contrôleur (21) est en outre configuré pour déterminer qu'une défaillance est survenue dans le pilote de commutateur (22) lorsque le nombre de fois est supérieur ou égal à une valeur de seuil.

4. Bloc-batterie (100) comprenant :
un module de batterie (30) ;
un commutateur (10) configuré pour commander une connexion électrique entre le module de batterie (30) et une charge (200) configurée pour recevoir de l'énergie électrique en provenance du bloc-batterie ; et
un dispositif de commande de commutateur (20) selon l'une quelconque des revendications 1 à 3 qui est configuré pour commander le commutateur (10).

5. Bloc-batterie (100) selon la revendication 4, dans lequel le commutateur (10) est un relais ou un contacteur dont l'ouverture et la fermeture sont commandées au moyen de l'activation d'une bobine incluse dans le commutateur (10), et le pilote de commutateur (22) est en outre configuré pour émettre en sortie le signal de pilotage sur au moins l'une de deux extrémités de la bobine.

6. Bloc-batterie (100) selon la revendication 5, dans lequel le compteur (23) est connecté à la borne de sortie du pilote de commutateur (22) ou à l'une des deux extrémités de la bobine.

7. Véhicule comprenant :
un bloc-batterie (100) selon l'une quelconque des revendications 4, 5 et 6 ; et
une charge (200) configurée pour recevoir de l'énergie électrique en provenance du bloc-batterie (100).
